(19) Europäisches Patentamt

European Patent Office

Office européen des brevets

(11) **EP 1 292 057 A1**

(12) **EUROPEAN PATENT APPLICATION**
published in accordance with Art. 158(3) EPC

(43) Date of publication:
**12.03.2003 Bulletin 2003/11**

(51) Int Cl.⁷: **H04L 1/00**, H03M 13/15, H04J 13/04

(21) Application number: **01902784.6**

(22) Date of filing: **06.02.2001**

(86) International application number:
**PCT/JP01/00830**

(87) International publication number:
**WO 02/063818 (15.08.2002 Gazette 2002/33)**

(84) Designated Contracting States:
**AT BE CH CY DE DK ES FI FR GB GR IE IT LI LU MC NL PT SE**

(71) Applicant: **MITSUBISHI DENKI KABUSHIKI KAISHA**
**Tokyo 100-8310 (JP)**

(72) Inventor: **UGA, Shinsuke,**
**c/o MITSUBISHI DENKI KABUSHIKI K.**
**Tokyo 100-8310 (JP)**

(74) Representative: **Popp, Eugen, Dr. et al**
**MEISSNER, BOLTE & PARTNER**
**Postfach 86 06 24**
**81633 München (DE)**

(54) **ERROR CORRECTING/DECODING METHOD**

(57) In an error correction decoding method of TFCI which is transmitted along with transmitted data and indicating a transmission format of the transmitted data, error correction performance is improved and the processing amount is reduced by eliminating, from comparison targets, any of transmission messages whose probability of occurrence can definitely be determined as 0 on a reception side as well as by excluding calculation itself of any of transmission messages whose probability of occurrence can definitely be determined as 0 on the reception side.

FIG. 3

```
              START
                |
        INITIAL VALUE      ~ SP1
          SETTING
                |
            INPUT DATA
                |
   MASK PATTERN SUPERPOSITION   ~ SP2
         (16 PATTERNS)
                |
        REARRANGEMENT      ~ SP3
                |
     HADAMARD TRANSFORM     ~ SP4
         PROCESSING
                |
    OBTAIN CORRELATED VALUES
    (LIKELIHOOD) FOR 64 CANDIDATES
                |
   SEARCH FOR MAXIMUM VALUE AMONG   ~ SP5
      THE 64 CANDIDATES
   (HOLD MAXIMUM LIKELIHOOD)
                |
              SP6
          GREATER THAN
   MAXIMUM LIKELIHOOD CURRENTLY  --NO-->
            HELD?
                |
              YES
                |
   UPDATE MAXIMUM LIKELIHOOD,    ~ SP7
      HOLD CORRESPONDING
      DECODED RESULT
                |
              SP8
   --NO--  16TH PROCESSING?
                |
              YES
                |
              End
```

EP 1 292 057 A1

## Description

Technical Field

The present invention relates to an error correction decoding method. More particularly, the present invention relates to an error correction decoding method of a Reed-Muller coded TFCI (Transport Format Combination Indicator) sent along with transmitted data in a communication system defined in the 3rd Generation Partnership Project (3GPP).

Background Art

In the 3GPP-defined communication system, various services have been made transportable to meet various demands in communications. The specifications define transmission rates supporting up to 2Mbps.

The services range from those for consecutive data like voice and moving pictures to those for high-speed packets, and a plurality of such services are multiplexed and transmitted on one or more channels on physical layers (Physical Channels).

In the 3GPP-defined communication system, to support the communication of various kinds of data as described above, an agreement has been made for the Transport Format Combination Set (TFCS) in the layer-3 messages. Which Transport Format Combination (TFC) among them is to be used for transmission is determined, according to the transfer volume, in the MAC (Medium Access Control) layer being a sub-layer of the second layer on the transmission side. Transmitted along with the data is an indicator of the transport format combination (Transport Format Combination Indicator, TFCI).

Based on the transport format selected in the second layer, error correction coding of the transmitted data itself and mapping to a physical channel are carried out. On the reception side, format conversion from the physical channel to a transport channel and error correction decoding processing should be carried out. As means for recognizing a transport format combination (TFC) used for the relevant transmission, the indicator of the transport format combination being sent along with the data is used. From this indicator of the transport format combination, the transport format combination set (TFCS) as described above is referred to, and the transport format combination (TFC) is recognized. The mapping from the physical channel to the channel for transport (Transport CH) and the error correction decoding processing are then carried out.

Since the relevant communication is radio communication, a case with poor transmission environment should be considered. In the 3GPP-defined communication system, it is defined that actual transmitted data is encoded using a Turbo code with a coding rate of 1/3 or a convolutional code with a coding rate of 1/2 or 1/3, for error correction protection.

It is further defined that the TFCI being sent along with the data is encoded using a (32,10) sub-code of second order Reed-Muller code or a (16,5) bi-orthogonal code (first order Reed-Muller code). Compared to the Turbo code and the convolutional code, the Reed-Muller code has relatively low correcting capability.

However, the conversion from the physical channel to the transport channel and the multiplexing processing as well as the subsequent error correction coding processing, as described above, are carried out based on the error correction decoded result of the TFCI. That is, any error in the TFCI detection will preclude proper error correction decoding of the data itself. The error correction performance of the TFCI creates a bottleneck, affecting the entire reception performance.

In general, a coding system is designed on the presumption that every input message will occur with equal probability, and the Reed-Muller coding is unexceptional. In the 3GPP-defined communication system, 10 bits or 1024 messages are assigned to the TFCI. From the standpoint of practical operation, however, it should be difficult to determine a TFCI from among 1024 candidates in TFCS. It is considered that not more than 64 patterns are normally used.

Furthermore, valid TFCI values are known to the reception side. That is, in practice, there must exist many TFCIs whose probability of occurrence is zero (0).

Disclosure of the Invention

Based on the foregoing, a main object of the present invention is to provide an error correction decoding method requiring less processing time which targets at only valid transmission messages to enhance error correcting performance.

The present invention resides in a decoding method which performs decoding processing by eliminating, from decoding targets, any of transmission messages whose probability of occurrence can definitely be determined as zero (0) on a reception side.

With this configuration, solely significant candidates are subjected to the processing. Thus, improvement of reception performance is expected, except for the case where a received word exists between valid code words in the code space.

In a preferred embodiment of the present invention, when comparing information indicating significance of decoded results such as likelihood at the time of maximum likelihood decoding, any of transmission messages whose probability of occurrence can definitely be determined as zero (0) on a reception side is eliminated from the comparison targets. This can be realized by adding to an existing decoding system solely a function to limit the comparison targets to the significant ones, which requires only small resources for installation. In addition, the processing amount of the comparison processing itself is reduced, which leads to reduction of the processing time.

Further, in a preferred embodiment of the present invention, calculation itself of the information indicating significance for any of transmission messages whose probability of occurrence can definitely be determined as zero (0) on a reception side is excluded. Such reduction of the calculation itself of the information indicating significance results in reduction of the processing time.

Further, in a preferred embodiment of the present invention, the decoding method uses Fast Hadamard Transform (FHT) to perform soft judgement decoding of a Reed-Muller code.

Further, in a preferred embodiment of the present invention, in order to limit comparison of information indicating significance for decoded results, the decoding method performs the comparison of the FHT output results only for the significant ones.

Further, in a preferred embodiment of the present invention, in order to limit calculation of information indicating significance for decoded results, the decoding method solely performs the FHT operation with only significant mask patterns being superposed.

Further, in a preferred embodiment of the present invention, in order to limit calculation of information indicating significance for decoded results, the decoding method performs, instead of the FHT operation, a vector operation on significant columns of the Hadamard matrix.

According to another aspect of the present invention, in an error correction decoding method of TFCI transmitted along with transmitted data and indicating a transmission format of the transmitted data, in the case where any TFCI whose probability of occurrence is not 0 has one or more bits being fixed, superposing processing of its mask patterns, operation processing and comparing processing therefor are eliminated.

Brief Description of the Drawings

Fig. 1 is a block diagram showing an entire configuration of a W-CDMA radio communication terminal device according to an embodiment of the present invention.
Fig. 2 shows a process flow of received data and TFCI for reception channel control of the communication path coding portion in Fig. 1.
Fig. 3 is a flow chart showing normal processing in the TFCI decoding processing.
Fig. 4 is a base table of the (32,10) sub-code of second order Reed-Muller code in an embodiment of the present invention.
Fig. 5 shows a coding scheme of the (32,10) sub-code of second order Reed-Muller code in an embodiment of the present invention.
Fig. 6 is a flow chart illustrating an embodiment of the present invention.

Fig. 7 shows an example of TFCI whose upper bits are 0.
Fig. 8 is a flow chart illustrating another embodiment of the present invention.
Fig. 9 is a flow chart illustrating yet another embodiment of the present invention.
Fig. 10 is a flow chart illustrating a still further embodiment of the present invention.

Best Modes for Carrying out the Invention

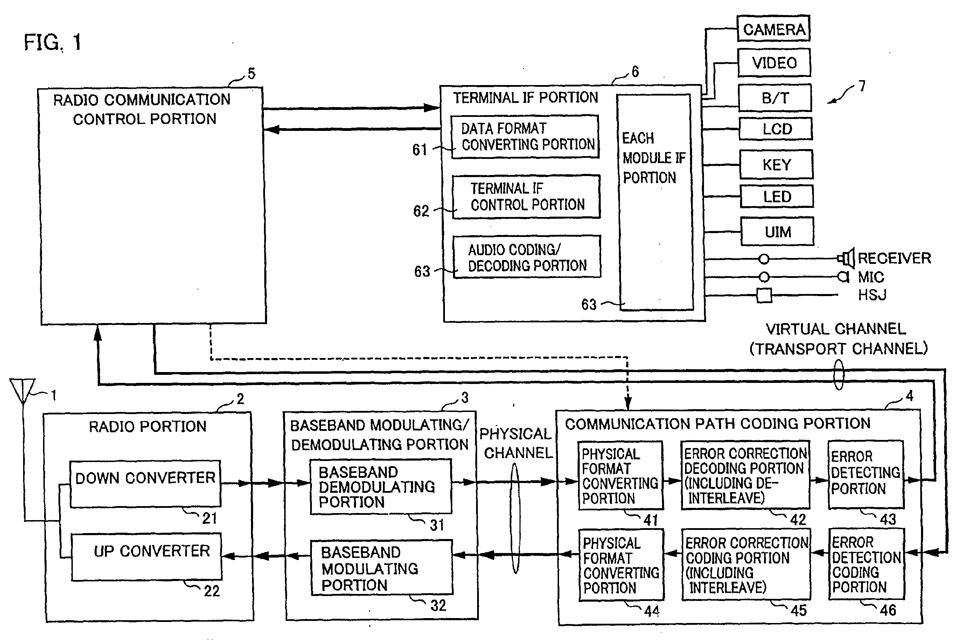

Fig. 1 is a block diagram showing an entire configuration of the W-CDMA radio communication terminal device according to an embodiment of the present invention. Referring to Fig. 1, an antenna 1 is connected to a radio portion 2. Radio portion 2 includes a down converter 21 and an up converter 22. Down converter 21 converts a high-frequency signal in a reception band to a baseband signal, and up converter 22 converts a baseband signal to a high-frequency signal in a transmission band.

A baseband signal modulating/demodulating portion 3 includes a baseband demodulating portion 31 and a baseband modulating portion 32. Baseband demodulating portion 31 performs baseband demodulation on an AD-converted signal down converted in the radio portion. In the CDMA system, despreading, Rake combining and others are carried out. Baseband modulating portion 32 performs baseband modulation on a signal that was subjected to error correction coding and converted to a physical channel in a communication path coding portion 4. In the CDMA system, spread modulation is carried out.

Communication path coding portion 4 includes a physical format converting portion 44, an error correction coding portion 45 including interleave, and an error detection coding portion 46 in a transmission system, and a physical format converting portion 41, an error correction decoding portion 42 including interleave, and an error detecting portion 43 in a reception system.

Physical format converting portion 41 multiplexes and demultiplexes one or more received physical channels to predetermined one or more transport channels. Error correction decoding portion 42 performs error correction decoding on a block of the transport channel(s). Error detecting portion 43 performs error detection on the corrected block of the transport channel(s). Error detection coding portion 46 performs addition of an error detection code to a block of one or more transport channels transferred from an upper layer. Error correction coding portion 45 performs error correction coding on data to which the error detection code was added. The physical format converting portion performs mapping of the block of the transport channel(s) to physical channel(s).

A radio communication control portion 5 performs protocol control for the radio communication, control of radio portion 2, baseband modulating/demodulating portion 3 and communication path coding portion 4 therefor, and communication with a terminal IF portion 6. Terminal IF portion 6 serves for module IF for a user IF of camera; LCD or the like; and includes a data format converting portion 61, a terminal IF control portion 62, an audio coding/decoding portion 63, and each module IF portion 64.

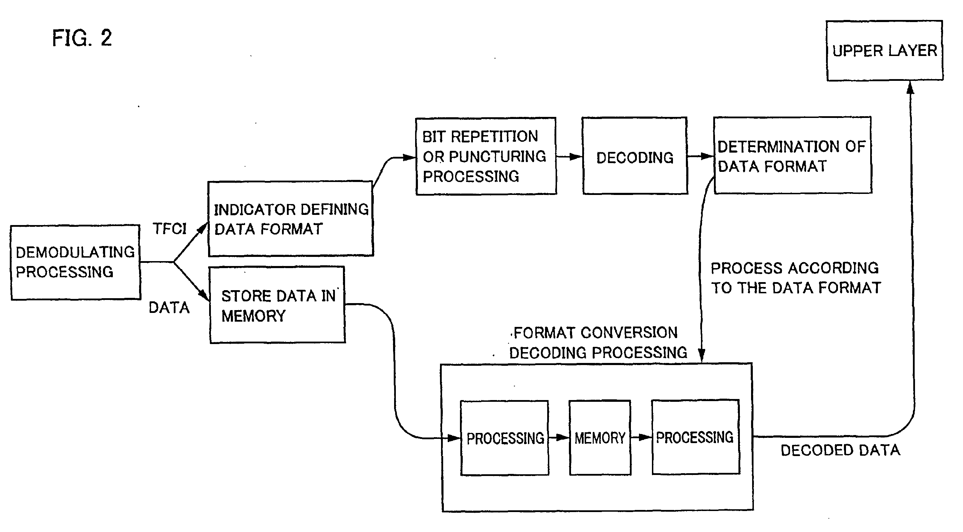

Fig. 2 shows a process flow of received data and TFCI for reception channel control of the communication path coding portion in an embodiment of the present invention. The TFCI and data having undergone the demodulation processing in baseband demodulating portion 3 shown in Fig. 1 are demultiplexed as shown in Fig. 2, and the data is temporarily stored in a memory. The TFCI undergoes, before being transmitted on a physical channel, processing for format matching with the physical channel, such as repetition or puncturing of certain bit(s). Thus, the TFCI is subjected to inverse processing of such repetition or puncturing, and is converted to an arbitrary number of bits after the error correction coding.

According to the 3GPP standards, it becomes 32 bits. Error correction decoding processing is conducted for the 32 bits, and the received TFCI is decoded. TFCS is referred to from this TFCI, and a current TFC is detected. Based thereon, multiplexing and demultiplexing processing of the data portion to the transport channel(s), error correction decoding processing and error detecting processing are carried out.

Hereinafter, specific operations normally conducted in an error correction decoding method adapted for TFCI will be described.

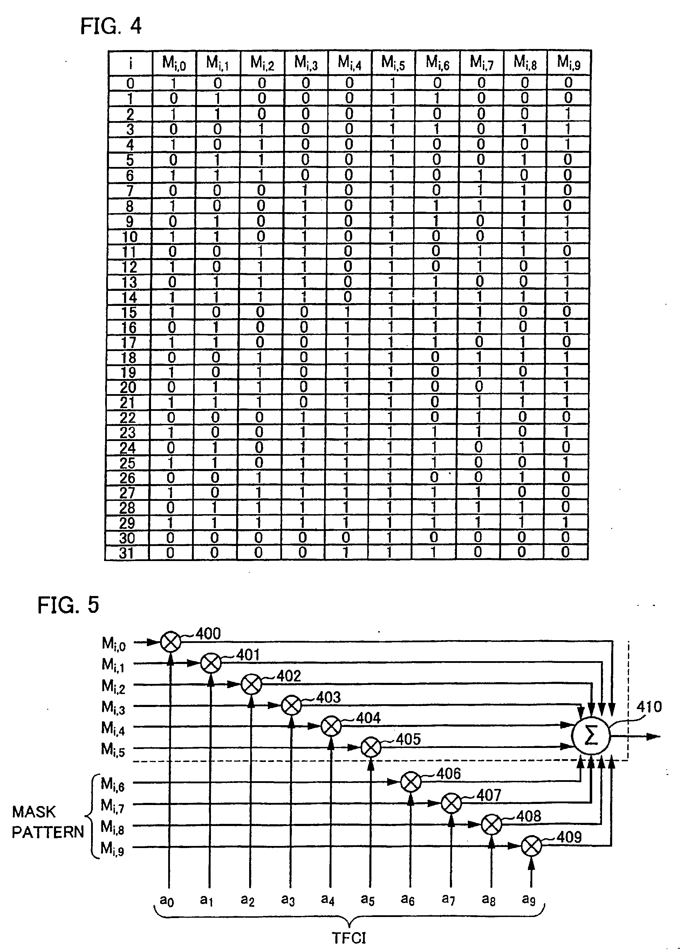

An example of the base table of (32,10) sub-code of second order Reed-Muller code is shown in Fig. 4.

Referring to Fig. 4, assume that $a_n$ (n is not less than 0 and not greater than 9, n=0 corresponds to the LSB and n=9 corresponds to the MSB) represents TFCI and $M_{i,n}$ represents the base table in Fig. 4. When the TFCI is being encoded using the (32,10) sub-code of second order Reed-Muller code, it is encoded as expressed by the following equation.

$$b_i = \sum_{n=0}^{9}(a_n \times M_{i,n})\bmod 2$$

Fig. 5 shows a coding scheme of the (32,10) sub-code of second order Reed-Muller code of the above equation.

Here, multiplication (mod2) on a bit basis of an arbitrary combination of $M_{i,6}$ - $M_{i,9}$ is called a mask pattern. Since they are arbitrary combinations of four (4) vectors of $M_{i,6}$ - $M_{i,9}$, there should be $2^4$ or 16 mask patterns. Codes from the base table shown in Fig. 4 are input into $M_{i,0}$ - $M_{i,5}$. Multiplication (mod2) of these codes and mask patterns and TFCI are conducted by multipliers 400-409, and the results of the multiplication are added by an adder 410.

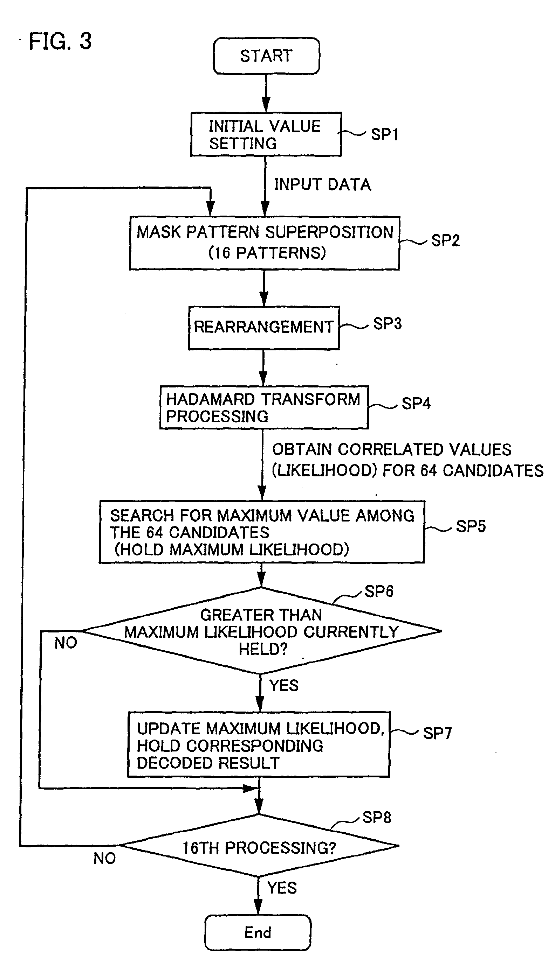

Fig. 3 is a flow chart illustrating normal processing of the TFCI decoding processing according to an embodiment of the present invention. Here, it is assumed that the TFCI is encoded using the (32,10) sub-code of second order Reed-Muller code.

In step (abbreviated as SP in the drawings) SP1 in Fig. 3, initial value setting is carried out by initializing the base table shown in Fig. 4, decode values and likelihood information. In step SP2, one of the 16 mask patterns is selected and, for a received word, multipliers 400-409 shown in Fig. 5 perform multiplication (mod2) on a bit basis, and adder 410 adds the multiplication results.

In step SP3, the bit columns having undergone the mask pattern superposition are rearranged in a different order to conform to the order for the Hadamard transform in step SP4. In the present embodiment, for example, the 31st bit is inserted into the first place, and the 32nd bit is inserted into the 17th place.

The Hadamard transform processing with the Hadamard matrix of 32 rows and 32 columns is carried out in step SP4, and 32 patterns of output values are obtained. This processing is carried out using an accelerating algorithm called Fast Hadamard Transform (FHT). In step SP5, a maximum value of absolute values of the 32 output values is searched for. It means that the maximum value has been detected from among the 64 values corresponding to a certain mask pattern.

Since there are 16 mask patterns, the maximum value among the 16 patterns should be obtained. To this end, in step SP6, it is determined whether the maximum value detected is greater than the maximum value currently held. If so, in step SP7, the maximum value is updated and a corresponding decoded result is held.

In step SP8, it is determined whether the processing has been repeated 16 times. A value corresponding to the maximum value obtained for the 16 mask patterns is output as a decoded result.

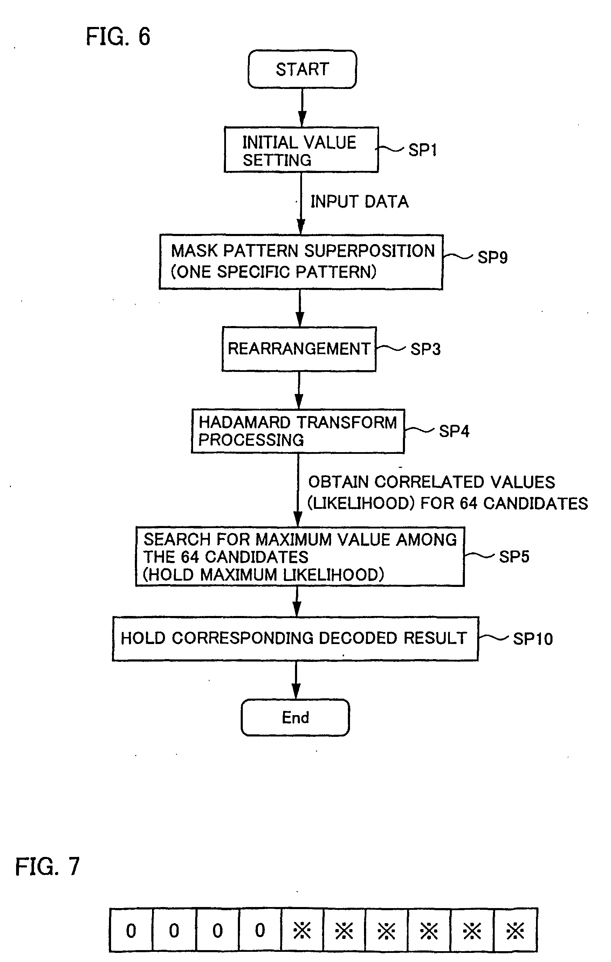

Fig. 6 is a flow chart of the decoding method according to an embodiment of the present invention. This embodiment corresponds to the case where upper 4 bits of 10 bits of the TFCI value are all 0 (i.e., TFCI is 0-63 in the decimal system), as shown in Fig. 7. In this case, in view of the fact, from Fig. 5, that a decoded result will not depend on a mask pattern, the mask pattern of all 0s is superposed in step SP9, and steps SP2,SP6, SP7 and SP8 in Fig. 3 are excluded. In practical use, if the TFCI value can be limited to 0-63 in the decimal system, the probability of occurrence of 64-1023 of the TFCI being sent is considered to be 0. In the present embodiment, calculation and comparison of the information indicating significance are limited to 0-63, so that improvement of reception performance is expected.

Further, the loop process as shown in Fig. 3 is unnecessary, which leads to simplification of the processing, reduction of the processing volume, and reduction of hardware or software resources necessary for implementation of such a loop function.

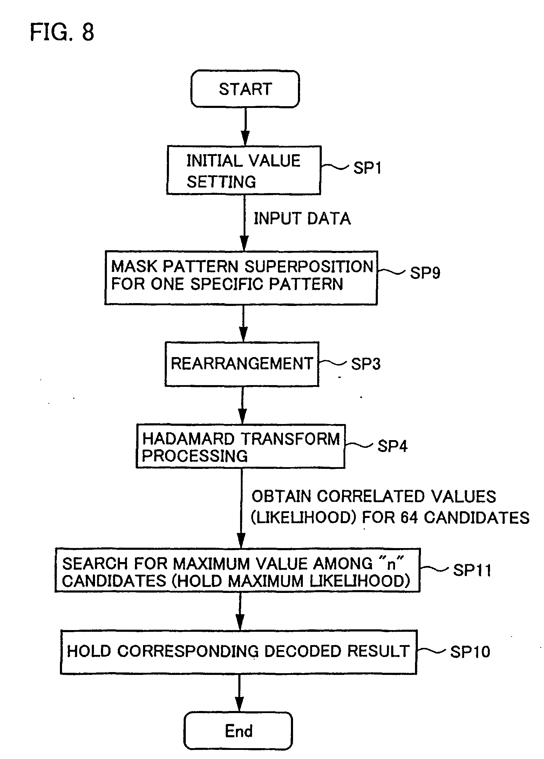

Fig. 8 is a flow chart of the decoding method according to another embodiment of the present invention. This embodiment also corresponds to the case where the upper 4 bits of the TFCI value are all 0 (i.e., TFCI of 0-63 in the decimal system). In practical use, candidates of TFCI to be sent are reported from an upper layer in advance by the TFCI, which vary in different communications. Thus, in the present embodiment, in addition to the embodiment shown in Fig. 6, the search of the maximum value is carried out by searching only the necessary TFCI during the relevant communication. In the present embodiment, comparison of the information indicating significance is further limited from 0-63 to arbitrary values. Thus, further improvement of the reception performance is expected.

In addition, reduction of the processing volume is expected as the number of candidates for the maximum value search decreases. However, implementation of a function to search the arbitrary values will require a slight increase of hardware or software resources.

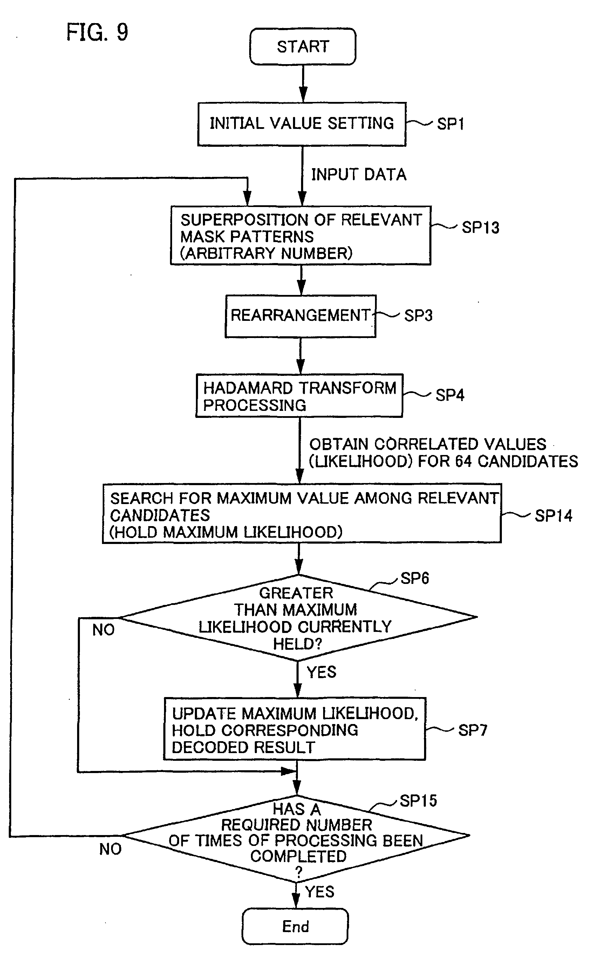

Fig. 9 is a flow chart of the decoding method according to yet another embodiment of the present invention.

In this embodiment, decoding is carried out for arbitrary TFCI candidates. Referring to Fig. 9, an arbitrary number of relevant mask patterns is superposed in step SP13. In step SP14, a maximum value within the relevant candidates is searched for. The process steps SP13, SP3, SP4, SP14, SP6, SP7 and SP15 are repeated until it is determined, in step SP15, that a required number of times of processing has been completed. The remaining operations are the same as those in Fig. 3.

The present embodiment offers great versatility, as it can perform decoding processing on an arbitrary number of arbitrary TFCI candidates (TFCS).

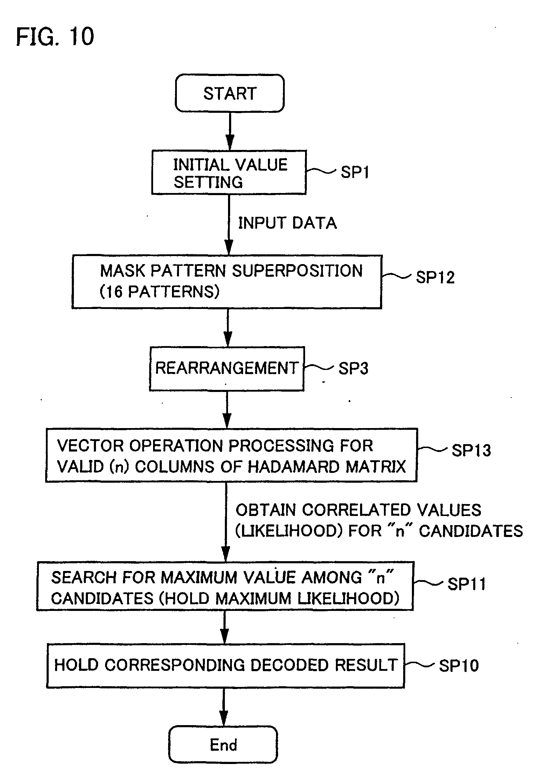

Fig. 10 is a flow chart of the decoding method according to a still further embodiment of the present invention.

In this embodiment, instead of the Hadamard transform processing in step SP4 shown in Figs. 3, 6, 8 and 9, vector operation processing is performed on valid columns of the Hadamard matrix. In other words, calculation itself of the information indicating significance is excluded for any invalid TFCI candidate.

Industrial Applicability

According to the present invention, error correction performance of error correction decoding performed on a transmission message including redundant bit assignment is improved, and the processing time therefor is shortened. Accordingly, the present invention is applicable to any apparatus requiring error correction coding processing for transmission of control signals, e. g., a radio terminal device like a mobile handset.

**Claims**

1. In decoding of an error correction coding system, a decoding method performing decoding processing by eliminating, from decoding targets, any of information being sent whose probability of occurrence can definitely be determined as 0 on a reception side.

2. In decoding of an error correction coding system, a decoding method, when comparing information indicating significance for decoded results, eliminating, from comparison targets, any of transmission messages whose probability of occurrence can definitely be determined as 0 on a reception side.

3. The decoding method according to claim 2, wherein said decoding is carried out by decoding Reed-Muller codes using Fast Hadamard Transform (FHT).

4. The decoding method according to claim 3, wherein only significant ones of FHT output results are compared in order to limit the comparison of the information indicating significance for the decoded results.

5. The decoding method according to claim 3, wherein the decoding is limited solely to the FHT operation with only significant mask patterns being superposed, in order to limit calculation of the information indicating significance for the decoded results.

6. The decoding method according to claim 3, wherein a vector operation is carried out for significant columns of the Hadamard matrix in order to limit calculation of the information indicating significance for said decoded results.

7. In decoding of an error correction coding system, a decoding method eliminating calculation itself of information indicating significance for any of transmission messages whose probability of occurrence can definitely be determined as 0 on a reception side.

8. The decoding method according to claim 7, wherein said decoding is carried out by decoding Reed-Muller codes using Fast Hadamard Transform (FHT).

9. The decoding method according to claim 8, wherein only significant ones of FHT output results are compared in order to limit comparison of the information indicating significance for the decoded results.

**10.** The decoding method according to claim 8, wherein the decoding is limited solely to the FHT operation with only significant mask patterns being superposed, in order to limit calculation of the information indicating significance for the decoded results.

**11.** The decoding method according to claim 8, wherein a vector operation is carried out for significant columns of the Hadamard matrix in order to limit calculation of the information indicating significance for said decoded results.

**12.** In an error correction decoding method of a Transport Format Combination Indicator (TFCI) transmitted along with transmitted data and indicating a transmission format of said transmitted data,
a decoding method, when every TFCI whose probability of occurrence is not 0 has one or more bits being fixed, excluding superposition processing of its mask patterns, operation processing and comparison processing therefor.

**FIG. 1**

RADIO COMMUNICATION CONTROL PORTION — 5

TERMINAL IF PORTION — 6

- DATA FORMAT CONVERTING PORTION — 61
- TERMINAL IF CONTROL PORTION — 62
- AUDIO CODING/ DECODING PORTION — 63

EACH MODULE IF PORTION — 63

- CAMERA
- VIDEO
- B/T — 7
- LCD
- KEY
- LED
- UIM
- RECEIVER
- MIC
- HSJ

VIRTUAL CHANNEL (TRANSPORT CHANNEL)

RADIO PORTION — 2
- DOWN CONVERTER — 21
- UP CONVERTER — 22

1

BASEBAND MODULATING/ DEMODULATING PORTION — 3
- BASEBAND DEMODULATING PORTION — 31
- BASEBAND MODULATING PORTION — 32

PHYSICAL CHANNEL

COMMUNICATION PATH CODING PORTION — 4
- PHYSICAL FORMAT CONVERTING PORTION — 41
- ERROR CORRECTION DECODING PORTION (INCLUDING DE-INTERLEAVE) — 42
- ERROR DETECTING PORTION — 43
- PHYSICAL FORMAT CONVERTING PORTION — 44
- ERROR CORRECTION CODING PORTION (INCLUDING INTERLEAVE) — 45
- ERROR DETECTION CODING PORTION — 46

EP 1 292 057 A1

FIG. 2

## FIG. 3

```
                    ┌──────────┐
                    │  START   │
                    └────┬─────┘
                         │
                         ▼
              ┌────────────────────┐
              │  INITIAL VALUE     │──── SP1
              │  SETTING           │
              └────────┬───────────┘
                       │ INPUT DATA
                       ▼
         ┌────────────────────────────────┐
         │ MASK PATTERN SUPERPOSITION      │──── SP2
         │ (16 PATTERNS)                   │
         └────────────┬───────────────────┘
                      │
                      ▼
              ┌──────────────────┐
              │  REARRANGEMENT   │──── SP3
              └────────┬─────────┘
                       │
                       ▼
         ┌──────────────────────────┐
         │ HADAMARD TRANSFORM       │──── SP4
         │ PROCESSING               │
         └────────────┬─────────────┘
                      │ OBTAIN CORRELATED VALUES
                      │ (LIKELIHOOD) FOR 64 CANDIDATES
                      ▼
   ┌────────────────────────────────────────┐
   │ SEARCH FOR MAXIMUM VALUE AMONG          │──── SP5
   │ THE 64 CANDIDATES                       │
   │ (HOLD MAXIMUM LIKELIHOOD)               │
   └────────────────┬───────────────────────┘
                    │
                    ▼
            ◇─────────────────────────◇ SP6
   NO       GREATER THAN
 ◄──────── MAXIMUM LIKELIHOOD CURRENTLY
            HELD?
            ◇─────────┬───────────────◇
                      │ YES
                      ▼
         ┌──────────────────────────┐
         │ UPDATE MAXIMUM LIKELIHOOD,│──── SP7
         │ HOLD CORRESPONDING        │
         │ DECODED RESULT            │
         └────────────┬─────────────┘
                      │
                      ▼
            ◇─────────────────────────◇ SP8
   NO        16TH PROCESSING?
 ◄────────  ◇─────────┬───────────────◇
                      │ YES
                      ▼
                 ┌─────────┐
                 │   End   │
                 └─────────┘
```

## FIG. 4

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ |
|---|---|---|---|---|---|---|---|---|---|---|
| 0 | 1 | 0 | 0 | 0 | 0 | 1 | 0 | 0 | 0 | 0 |
| 1 | 0 | 1 | 0 | 0 | 0 | 1 | 1 | 0 | 0 | 0 |
| 2 | 1 | 1 | 0 | 0 | 0 | 1 | 0 | 0 | 0 | 1 |
| 3 | 0 | 0 | 1 | 0 | 0 | 1 | 1 | 0 | 1 | 1 |
| 4 | 1 | 0 | 1 | 0 | 0 | 1 | 0 | 0 | 0 | 1 |
| 5 | 0 | 1 | 1 | 0 | 0 | 1 | 0 | 0 | 1 | 0 |
| 6 | 1 | 1 | 1 | 0 | 0 | 1 | 0 | 1 | 0 | 0 |
| 7 | 0 | 0 | 0 | 1 | 0 | 1 | 0 | 1 | 1 | 0 |
| 8 | 1 | 0 | 0 | 1 | 0 | 1 | 1 | 1 | 1 | 0 |
| 9 | 0 | 1 | 0 | 1 | 0 | 1 | 1 | 0 | 1 | 1 |
| 10 | 1 | 1 | 0 | 1 | 0 | 1 | 0 | 0 | 1 | 1 |
| 11 | 0 | 0 | 1 | 1 | 0 | 1 | 0 | 1 | 1 | 0 |
| 12 | 1 | 0 | 1 | 1 | 0 | 1 | 0 | 1 | 0 | 1 |
| 13 | 0 | 1 | 1 | 1 | 0 | 1 | 1 | 0 | 0 | 1 |
| 14 | 1 | 1 | 1 | 1 | 0 | 1 | 1 | 1 | 1 | 1 |
| 15 | 1 | 0 | 0 | 0 | 1 | 1 | 1 | 1 | 0 | 0 |
| 16 | 0 | 1 | 0 | 0 | 1 | 1 | 1 | 1 | 0 | 1 |
| 17 | 1 | 1 | 0 | 0 | 1 | 1 | 1 | 0 | 1 | 0 |
| 18 | 0 | 0 | 1 | 0 | 1 | 1 | 0 | 1 | 1 | 1 |
| 19 | 1 | 0 | 1 | 0 | 1 | 1 | 0 | 1 | 0 | 1 |
| 20 | 0 | 1 | 1 | 0 | 1 | 1 | 0 | 0 | 1 | 1 |
| 21 | 1 | 1 | 1 | 0 | 1 | 1 | 0 | 1 | 1 | 1 |
| 22 | 0 | 0 | 0 | 1 | 1 | 1 | 0 | 1 | 0 | 0 |
| 23 | 1 | 0 | 0 | 1 | 1 | 1 | 1 | 1 | 0 | 1 |
| 24 | 0 | 1 | 0 | 1 | 1 | 1 | 1 | 0 | 1 | 0 |
| 25 | 1 | 1 | 0 | 1 | 1 | 1 | 1 | 0 | 0 | 1 |
| 26 | 0 | 0 | 1 | 1 | 1 | 1 | 0 | 0 | 1 | 0 |
| 27 | 1 | 0 | 1 | 1 | 1 | 1 | 1 | 1 | 0 | 0 |
| 28 | 0 | 1 | 1 | 1 | 1 | 1 | 1 | 1 | 1 | 0 |
| 29 | 1 | 1 | 1 | 1 | 1 | 1 | 1 | 1 | 1 | 1 |
| 30 | 0 | 0 | 0 | 0 | 0 | 1 | 0 | 0 | 0 | 0 |
| 31 | 0 | 0 | 0 | 0 | 1 | 1 | 1 | 0 | 0 | 0 |

## FIG. 5

## FIG. 6

```
        START
          │
          ▼
  ┌─────────────────┐
  │ INITIAL VALUE   │ ─── SP1
  │ SETTING         │
  └─────────────────┘
          │
          │ INPUT DATA
          ▼
  ┌──────────────────────────┐
  │ MASK PATTERN SUPERPOSITION│ ─── SP9
  │ (ONE SPECIFIC PATTERN)    │
  └──────────────────────────┘
          │
          ▼
  ┌─────────────────┐
  │ REARRANGEMENT   │ ─── SP3
  └─────────────────┘
          │
          ▼
  ┌─────────────────────┐
  │ HADAMARD TRANSFORM  │ ─── SP4
  │ PROCESSING          │
  └─────────────────────┘
          │
          │ OBTAIN CORRELATED VALUES
          │ (LIKELIHOOD) FOR 64 CANDIDATES
          ▼
  ┌───────────────────────────────┐
  │ SEARCH FOR MAXIMUM VALUE AMONG │ ─── SP5
  │ THE 64 CANDIDATES             │
  │ (HOLD MAXIMUM LIKELIHOOD)     │
  └───────────────────────────────┘
          │
          ▼
  ┌──────────────────────────────────┐
  │ HOLD CORRESPONDING DECODED RESULT │ ─── SP10
  └──────────────────────────────────┘
          │
          ▼
         End
```

## FIG. 7

| 0 | 0 | 0 | 0 | ※ | ※ | ※ | ※ | ※ | ※ |
|---|---|---|---|---|---|---|---|---|---|

FIG. 8

```
                    ┌─────────────┐
                    │    START    │
                    └─────────────┘
                           │
                           ▼
                   ┌─────────────────┐
                   │ INITIAL VALUE   │──── SP1
                   │ SETTING         │
                   └─────────────────┘
                           │
                           │  INPUT DATA
                           ▼
              ┌──────────────────────────────┐
              │ MASK PATTERN SUPERPOSITION    │──── SP9
              │ FOR ONE SPECIFIC PATTERN      │
              └──────────────────────────────┘
                           │
                           ▼
                   ┌─────────────────┐
                   │ REARRANGEMENT   │──── SP3
                   └─────────────────┘
                           │
                           ▼
                 ┌──────────────────────┐
                 │ HADAMARD TRANSFORM    │──── SP4
                 │ PROCESSING            │
                 └──────────────────────┘
                           │
                           │  OBTAIN CORRELATED VALUES
                           │  (LIKELIHOOD) FOR 64 CANDIDATES
                           ▼
          ┌────────────────────────────────────────┐
          │ SEARCH FOR MAXIMUM VALUE AMONG "n"      │──── SP11
          │ CANDIDATES (HOLD MAXIMUM LIKELIHOOD)    │
          └────────────────────────────────────────┘
                           │
                           ▼
          ┌────────────────────────────────────────┐
          │ HOLD CORRESPONDING DECODED RESULT       │──── SP10
          └────────────────────────────────────────┘
                           │
                           ▼
                    ┌─────────────┐
                    │     End     │
                    └─────────────┘
```

FIG. 9

```
                    ┌──────────┐
                    │  START   │
                    └──────────┘
                          │
                          ▼
          ┌───────────────────────────────┐
          │  INITIAL VALUE SETTING         │───  SP1
          └───────────────────────────────┘
                          │
                          │ INPUT DATA
                          ▼
          ┌───────────────────────────────┐
          │  SUPERPOSITION OF RELEVANT     │───  SP13
          │  MASK PATTERNS                 │
          │  (ARBITRARY NUMBER)            │
          └───────────────────────────────┘
                          │
                          ▼
             ┌───────────────────────┐
             │  REARRANGEMENT         │───  SP3
             └───────────────────────┘
                          │
                          ▼
          ┌───────────────────────────────┐
          │  HADAMARD TRANSFORM            │───  SP4
          │  PROCESSING                    │
          └───────────────────────────────┘
                          │
                          │ OBTAIN CORRELATED VALUES
                          │ (LIKELIHOOD) FOR 64 CANDIDATES
                          ▼
       ┌──────────────────────────────────────┐
       │  SEARCH FOR MAXIMUM VALUE AMONG       │
       │  RELEVANT CANDIDATES                  │───  SP14
       │  (HOLD MAXIMUM LIKELIHOOD)            │
       └──────────────────────────────────────┘
                          │
                          ▼
                   ╱──────────────╲             SP6
           NO     ╱  GREATER        ╲
       ◀─────────◀   THAN MAXIMUM    ▶
                  ╲  LIKELIHOOD       ╱
                   ╲ CURRENTLY HELD? ╱
                    ╲──────────────╱
                          │ YES
                          ▼
          ┌───────────────────────────────┐
          │  UPDATE MAXIMUM LIKELIHOOD,    │───  SP7
          │  HOLD CORRESPONDING            │
          │  DECODED RESULT                │
          └───────────────────────────────┘
                          │
                          ▼
                   ╱──────────────╲             SP15
           NO     ╱  HAS A          ╲
       ◀─────────◀  REQUIRED NUMBER  ▶
                  ╲ OF TIMES OF       ╱
                   ╲PROCESSING BEEN  ╱
                    ╲ COMPLETED ?   ╱
                     ╲────────────╱
                          │ YES
                          ▼
                    ┌──────────┐
                    │   End    │
                    └──────────┘
```

FIG. 10

```
                    ┌──────────────┐
                    │    START     │
                    └──────┬───────┘
                           │
                           ▼
              ┌──────────────────────┐
              │   INITIAL VALUE      │──── SP1
              │   SETTING            │
              └──────────┬───────────┘
                         │
                    INPUT DATA
                         │
                         ▼
        ┌──────────────────────────────────┐
        │  MASK PATTERN SUPERPOSITION       │──── SP12
        │  (16 PATTERNS)                    │
        └────────────────┬─────────────────┘
                         │
                         ▼
              ┌──────────────────────┐
              │  REARRANGEMENT       │──── SP3
              └──────────┬───────────┘
                         │
                         ▼
    ┌─────────────────────────────────────────┐
    │  VECTOR OPERATION PROCESSING FOR         │──── SP13
    │  VALID (n) COLUMNS OF HADAMARD MATRIX    │
    └──────────────────┬──────────────────────┘
                       │
            OBTAIN CORRELATED VALUES
            (LIKELIHOOD) FOR "n" CANDIDATES
                       │
                       ▼
    ┌─────────────────────────────────────────┐
    │  SEARCH FOR MAXIMUM VALUE AMONG "n"      │──── SP11
    │  CANDIDATES (HOLD MAXIMUM LIKELIHOOD)    │
    └──────────────────┬──────────────────────┘
                       │
                       ▼
    ┌─────────────────────────────────────────┐
    │  HOLD CORRESPONDING DECODED RESULT       │──── SP10
    └──────────────────┬──────────────────────┘
                       │
                       ▼
              ┌──────────────────────┐
              │        End           │
              └──────────────────────┘
```

## INTERNATIONAL SEARCH REPORT

| | International application No. |
|---|---|
| | PCT/JP01/00830 |

A. CLASSIFICATION OF SUBJECT MATTER
   Int.Cl⁷   H04L1/00, H03M13/15, H04J13/04

According to International Patent Classification (IPC) or to both national classification and IPC

B. FIELDS SEARCHED

Minimum documentation searched (classification system followed by classification symbols)
   Int.Cl⁷   H04L1/00, H03M13/15, H04J13/00

Documentation searched other than minimum documentation to the extent that such documents are included in the fields searched
   Jitsuyo Shinan Koho          1926-1996     Toroku Jitsuyo Shinan Koho  1994-2000
   Kokai Jitsuyo Shinan Koho    1971-2000     Jitsuyo Shinan Toroku Koho  1996-2000

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP, 10-112130, A (NEC Corporation), | 1,2,7 |
| Y | 28 April, 1998 (28.04.98), | 3,8 |
| A | Claims 1 to 3 | 4-6,9-12 |
| | & US, 6014356, A | |
| X | JP, 61-7730, A (NEC Corporation), | 1,2,7 |
| Y | 14 January, 1986 (14.01.86), | 3,8 |
| A | page 2, upper left column, line 7 to lower left column, line 20; Fig. 2  (Family: none) | 4-6,9-12 |
| Y | JP, 2000-516072, A (Hewlett-Packard Company), | 3,8 |
| A | 28 November, 2000 (28.11.00), page 45, line 13 to page 47, line 26; Fig. 11 & EP, 860072, A2 | 1,2,4-7,9-12 |
| A | JP, 9-74359, A (Fujitsu Limited), 18 March, 1997 (18.03.97), Full text  (Family: none) | 1-12 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 April, 2001 (06.04.01) | 17 April, 2001 (17.04.01) |

| Name and mailing address of the ISA/ | Authorized officer |
|---|---|
| Japanese Patent Office | |
| Facsimile No. | Telephone No. |

Form PCT/ISA/210 (second sheet) (July 1992)

15

# EP 1 292 057 A1

**INTERNATIONAL SEARCH REPORT**

| | International application No. |
|---|---|
| | PCT/JP01/00830 |

**C (Continuation). DOCUMENTS CONSIDERED TO BE RELEVANT**

| Category* | Citation of document, with indication, where appropriate, of the relevant passages | Relevant to claim No. |
|---|---|---|
| A | 3GPP, "3GPP TS25.212 3rd Generation Partnership Project; Technical Specification Group Radio Access Network; Multiplexing and channel coding (FDD) (Release1999)", V3.4.0, October 2000, "4.3.3 Coding of Transport-Format-Combination Indicator (TFCI)", Internet <URL:http://www.3gpp.org/ftp/Specs/2000-09/R1999/25_series/> | 1-12 |

Form PCT/ISA/210 (continuation of second sheet) (July 1992)

16